# EUROPÄISCHE PATENTANMELDUNG

(11) **EP 4 071 800 A1**
(43) Veröffentlichungstag der Anmeldung: **12.10.2022**
(21) Anmeldenummer: 21167362.9
(22) Anmeldetag: 08.04.2021
(51) Int. Cl.: H01L 23/427, H01L 23/13

(54) **HALBLEITERCHIPANORDNUNG MIT KÜHLUNG**

(71) Anmelder: Siemens Aktiengesellschaft, 80333 München (DE)
(72) Erfinder: Danov, Vladimir, 91056 Erlangen (DE); Dennerlein, Klaus, 91058 Erlangen (DE); Schwarz, Florian, 90766 Fürth (DE); Wohlfart, Manfred, 91369 Wiesenthau (DE)

(57) **Zusammenfassung**

Für eine effektive und platzsparende Kühlung von Halbleiterchips werden diese auf Wänden eines Kanals montiert, der von innen gekühlt wird. Es wird ein zweiphasiges Kühlverfahren eingesetzt.

## Beschreibung

Die Erfindung betrifft eine Anordnung und ein Verfahren zum Kühlen von Halbleiterchips

Beim Betrieb von Halbleiterbauelementen wird die Verlustleistung in Wärme umgewandelt. Insbesondere bei Halbleiterchips kann dies aufgrund ihrer geringen Masse zu einem schnellen und starken Anstieg der Temperatur führen und damit zu einem Ausfall aufgrund thermischer Überlastung. Die Gefahr wird weiter vergrößert durch starke Temperaturwechsel. Mit steigender Integrationsdichte der Chips und der Schaltungen auf dem Chip erhöht sich die im Betrieb auftretende Wärmemenge, insbesondere der Wärmemenge pro Fläche.

Um die kurzzeitige Überlastfähigkeit eines Chips sicherzustellen, muss die Kühlung ausreichend schnell erfolgen; die dafür benötigte Zeit τ lässt sich gemäß τ=(mcₚ)/αA bestimmen, wobei m - die Masse des Chips, cₚ - die spezifische Wärmekapazität des Chips, a - der Wärmeübertragungskoeffizient und A - die Oberfläche des Chips ist. Typischerweise benötigt ein Chip ca. 2 ms bis zum Erreichen der maximalen Temperatur. Für eine ausreichend schnelle Kühlung sind Wärmeübertragungskoeffizienten in der Größenordnung von 100 kW/m² notwendig.

Ein weiterer wichtiger Faktor ist von der Kühlung beanspruchte Platz, da ein hoher Platzbedarf der gewünschten hohen Integrationsdichte entgegenwirkt. Zudem muss für eine effektive Kühlung diese möglichst nah am Chip platziert sein.

Es sind verschiedene Möglichkeiten zur Wärmeabfuhr, d.h. für eine möglichst effektive thermische Anbindung, bei Halbleiteranordnungen bekannt.

Eine Möglichkeit ist, die im Betrieb eines Chips entstehende Wärme auf eine möglichst große Fläche zu spreizen, beispielsweise durch Kühlrippen. Der laterale Wärmetransport kann durch Auswahl geeigneter Materialien des Chipträgers, ggf. mehrschichtige Träger, weiter verbessert werden. Trotzdem benötigt diese Lösung relativ viel Platz.

Eine andere Möglichkeit ist die Sprühkühlung, bei der eine Flüssigkeit - beispielsweise Wasser - vorzugsweise auf die Rückseite des Chip-Trägers aufgesprüht wird. Dabei verdampft die Flüssigkeit zumindest teilweise. An der Oberfläche des Trägers bildet sich eine Flüssigkeitsschicht, die einen ausreichend schnellen Abtransport der entstehenden Gasblasen (insbesondere in den geforderten 2 ms) erschwert, so dass die kurzfristige Überlastfestigkeit nicht gewährleistet werden kann. Um den störenden Flüssigkeitsfilm zu verhindern, muss eine aufwändige Steuerung der Sprühkühlung eingesetzt werden. Ferner erfordert das kontinuierliche Aufsprühen eine entsprechende Pumpleistung und ist daher mit einem Verschleißrisiko verbunden.

Aufgabe der Erfindung ist es, eine Anordnung und ein Verfahren zur Kühlung von Halbleiterchips anzugeben, das effektiv ist und einen geringen Platzbedarf aufweist.

Diese Aufgaben werden gelöst durch ein Verfahren mit den Merkmalen des Patentanspruchs 1 und durch eine Anordnung mit den Merkmalen des Patentanspruchs 12. Vorteilhafte Ausgestaltungen der Erfindung sind in den Unteransprüchen angegeben.

Die Erfindung sieht vor, die zu kühlenden Halbleiterchips auf den Wänden eines Kanals anzuordnen und das Innere des Kanals bzw. die Kanalwände mittels einer zweiphasigen Kühlung zu kühlen. Es ist mindestens eine Komponente einer zweiphasigen Kühleinrichtung im Kanal oder in den Wänden des Kanals angeordnet. Eine Zwei-Phasen-Kühlung kann den geforderten Wärme-übertragungskoeffizienten gewährleisten. Dieses Kühlprinzip nutzt die latente Wärme, also die Verdampfungsenthalpie zur Kühlung. Eine Zwei-Phasen-Kühlung kann durch verschiedene Verfahren technisch umgesetzt werden. Beispielsweise kann eine Sprühkühlung eingesetzt werden. Es kann auch ein passives zweiphasiges Kühlverfahren eingesetzt werden, beispielsweise ein Thermosiphon-Kreislauf oder ein Wärmerohr (sogenannte Heat Pipe), insbesondere eine pulsierende Heat Pipe oder eine sogenannte Loop Heat Pipe (in sich geschlossene Heat Pipe). Passive Kühlverfahren sind besonders zuverlässig und einfach und benötigen wenig apparativen Aufwand.

Die genannten Kühlverfahren an sich sind bekannt und beispielsweise in folgenden Dokumenten mit unterschiedlichen Aspekten und Lösungen, die nicht alle relevant für die Erfindung sind, beschrieben: Thermal Characteristics of Graphite Foam Thermosyphon for Electronics Cooling (Journal of Mechanical Science and Technology (KSME Int. J.), VoL 19, No. 10, pp. 1932-- 1938, 2005); Two-Phase Microchannel Heat Sinks (Journal of Electronic Packaging , DECEMBER 2011, Vol. 133 / 041002-1); Micro Loop Heat Pipe for Mobile Electronics Applications (31st SEMI-THERM Symposium, 978-1-4799-8600-2/15/$31.00 ©2015 IEEE); An overview on the developing trend of pulsating heat pipe and its performance (Applied Thermal Engineering 141 (2018) 305-332); Experimental and Theoretical Investigations of Thermosyphons (Dissertation V. Danov, Universität Erlangen-Nürnberg, 2007); Thermal Management of Power Electronics and Electric Motors for Electric-Drive Vehicles (IEEE Energy Conversion Congress & Expo, Pittsburgh, USA, September 14-18, 2014).

Bei der erfindungsgemäßen Lösung wird die Wärme zunächst durch das Substrat gespreizt und anschließend durch das dadurch siedende Arbeitsmedium aufgenommen. Dadurch, dass mehrere Chips mit Hilfe von einem Kanal gekühlt werden können, wird das Volumen des Gesamtsystem reduziert.

Die Wände des Kanals können durch das Substrat oder die Leiterplatten gebildet werden, auf dem die Chips montiert sind. Alternativ kann der Kanal Wände mit ausreichend guter Wärmeleitung (beispielsweise aus Metall) aufweisen, auf denen die Chips mit ihrem Substrat montiert sind. Die Chips können auf den Außenwänden und/oder auf den Innenwänden des Kanals angeordnet sein.

Der Kanal kann einen mehreckigen Querschnitt haben. Dabei hat der Kanal vorzugsweise drei bis acht Wände, also einen dreieckigen bis achteckigen Querschnitt. Besonders bevorzugt ist ein Kanal mit sechs Wänden, also mit einem sechseckigen Querschnitt, da dies zu einem günstigen Verhältnis zwischen Platzbedarf und Kühleffizienz führt.

Als Arbeitsmedium kann beispielsweise Wasser, Aceton, Äthanol oder ein Wärmeleitmittel wie Novec 649 oder Novec 7100 verwendet werden. Die genannten Wärmeleitmittel zeichnen sich durch hohe Betriebssicherheit, Umweltverträglichkeit und sehr günstige physikalische und chemische Eigenschaften aus.

Bei Einsatz einer Sprühkühlung kann diese mit einer zentralen Düse mit radial verteilten Öffnungen (entsprechend der Geometrie des Kanals) erfolgen, wodurch mehrere Chips gleichzeitig gekühlt werden. Je nach Länge des Kanals können mehrere Düsen nacheinander auf der Mittelachse des Kanals vorgesehen sein.

Bei Einsatz eines Thermosiphon-Kreislaufs oder einer Loop Heat Pipe dient der Kanal als Verdampfer, d.h. das Arbeitsmedium wird durch den Kanal geführt und verdampft unter Wärmeaufnahme. Die gleichmäßige Wärmeverteilung über der Wand begünstigt den Verdampfungsprozess. Der Kanal ist dabei insbesondere an der Eintrittsseite und an der Austrittsseite der das Arbeitsmedium führenden Leitung verschlossen.

Bei Einsatz einer pulsierenden Heat Pipe ist es vorteilhaft, wenn die beispielsweise in Windungen ausgeführte Leitung (Kapillare), in der sich das Arbeitsmedium befindet, direkt in den Kanalwänden angeordnet ist. Die pulsierende Heat Pipe ist dann quasi in den Kanalwänden verbaut. Im Inneren des Kanals können zusätzlich Kühlrippen vorgesehen sein, die wiederum mit Luft oder Wasser gekühlt werden. Die pulsierende Heat Pipe verteilt in diesem Fall die Wärme auf die Kühlrippen, wo sie je nach Leistungsdichte mit Flüssigkeits- oder Luftkühlung abgeführt wird.

Die Erfindung wird im Folgenden anhand von Ausführungsbeispielen, die in den Figuren dargestellt sind, näher erläutert. Es zeigen
Fig.1 eine Ausführungsform mit einer Anordnung von Chips auf Außenwänden eines Kanals
Fig.2 eine Ausführungsform, bei der ein Thermosiphon-Kühlkreislauf verwendet wird
Fig.3 einen Querschnitt durch den Kanal gemäß einer Ausführungsform, bei der die Chips auf den Außenwänden des Kanals angeordnet sind und eine Sprühkühlung verwendet wird
Fig.4 einen Querschnitt durch den Kanal gemäß einer Ausführungsform, bei der die Chips auf den Innenwänden des Kanals angeordnet sind und eine Sprühkühlung verwendet wird
Fig.5 einen Querschnitt durch den Kanal gemäß einer Ausführungsform, bei der eine pulsierende Heat Pipe verwendet wird
Fig. 6 eine schematische Darstellung einer Ausführungsform, bei der eine pulsierende Heat Pipe verwendet wird
Fig.7 eine Ausführungsform, bei der eine Loop Heat Pipe verwendet wird

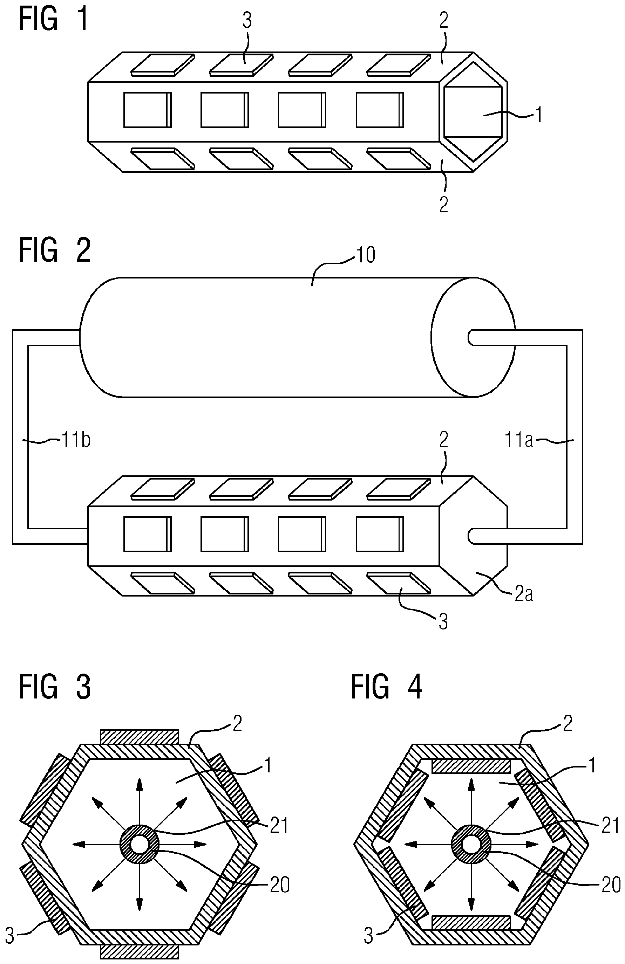

Figur 1 zeigt einen Kanal 1 mit sechseckigem Querschnitt, der von sechs Wänden 2 begrenzt wird. Die Wände 2 werden durch ein Substrat gebildet, auf dem die zu kühlenden Halbleiter-chips 3 montiert sind. Die Dimensionen der Wände werden entsprechend der Größe und Anzahl der Chips gewählt, wobei die Chips auch in mehrere Reihen oder in einer anderen beliebigen Anordnung auf jeder Seite angeordnet werden können. Alternativ oder zusätzlich ist es möglich, die Chips auf der Innenseite des Kanals anzuordnen, unabhängig von der jeweils eingesetzten zweiphasigen Kühlung.

Figur 2 zeigt eine Ausführungsform eines Kühlsystems mit auf Kanalaußenwänden angebrachten Chips 3 gemäß Figur 1, einem Kondensator 10 und Leitungen 11a, 11b für das Arbeitsmedium. Dieses System kann als Thermosiphon-Kreislauf betrieben werden. Das Arbeitsmedium, beispielsweise Novec 649, verläuft in bekannter Weise vom Kondensator 10 durch die Leitung 11a zum Kanal 1, wo es unter Wärmeaufnahme verdampft. Das gasförmige Arbeitsmedium läuft dann durch die Leitung 11b wieder zum Kondensator, wo es durch Luft- oder Wasserkühlung wieder verflüssigt wird.

In dem Thermosiphon-Kreislaufs zirkuliert das Arbeitsmedium aufgrund natürlicher Konvektion, basierend auf dem Dichteunterschied, der durch die Wärmeausdehnung des Mediums hervorgerufen wird. Der Kondensator 10 muss höher angeordnet sein als der Verdampfer, d.h. als der mit den Chips 3 bestückte Kanal 1. Vorzugsweise wird das gesamte Innere des Kanals 1 als Verdampfer genutzt. Der Kanal besitzt daher Wände 2a an der Eintritts- und der Austrittsseite der Leitungen 11a, 11b, in die die Leitungen 11a, 11b münden und die den Kanal 1 abdichten. Der Kanal kann auch eine innere Struktur für die Führung des Arbeitsmediums aufweisen, um die Wärmeaufnahme und die Verdampfung zu optimieren.

Figur 3 zeigt einen Querschnitt durch einen mit Chips 3 bestückten Kanal 1, bei dem als zweiphasige Kühlung eine Sprühkühlung eingesetzt wird. Im Kanal verläuft eine Leitung 20, durch die das Arbeitsmedium gepumpt wird. Über Sprühöffnungen 21, die über den Umfang der Leitung 20 verteilt sind, wird das Arbeitsmedium gegen die Wände des Kanals 1 gesprüht, also gegen das Substrat. Hier verdampft es unter Wärmeaufnahme. Das gasförmige Arbeitsmedium wird in geeigneter Weise wieder kondensiert und gesammelt. Die im Kreislauf des Arbeitsmediums befindliche, nicht dargestellte Pumpe ist vorzugsweise steuerbar, so dass der Sprühvorgang der benötigten Kühlleistung angepasst werden kann. Damit kann auch bei schnellen Änderungen in der Leistungsaufnahme der Chips eine zuverlässige Kühlung erfolgen.

Die Anzahl und Anordnung der Sprühdüsen sind auf die Dimensionierung des Kanals abgestimmt, um eine optimale Kühlung zu erreichen. Insbesondere ist eine ausreichende Anzahl an Düsen bzw. deren Öffnungen vorgesehen, um die Chips zu besprühen.

Figur 4 zeigt eine modifizierte Anordnung, bei der die Chips auf den Innenwänden des Kanals angeordnet sind, und die im übrigen Figur 3 entspricht. Es ist auch möglich, Chips innen und außen auf den Kanalwänden anzuordnen, wobei dies vorzugsweise an verschiedenen Stellen der Wände erfolgt, um die Kühlung eines außen montierten Chips nicht durch einen an selber Stelle innen montierten Chip zu verschlechtern.

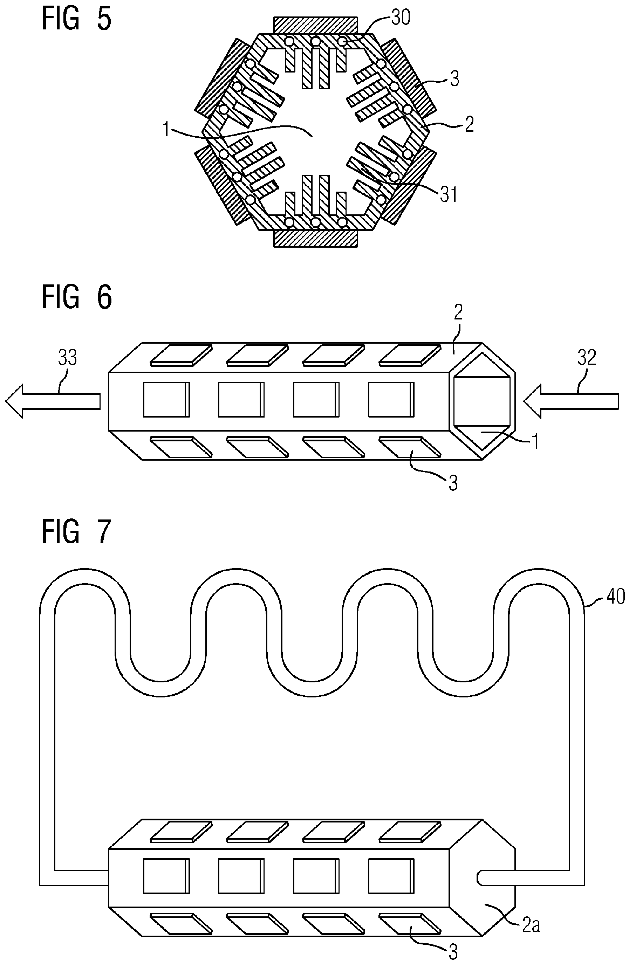

Figur 5 zeigt einen Querschnitt durch einen mit Chips 3 bestückten Kanal, bei dem für die zweiphasige Kühlung eine pulsierende Heat Pipe verwendet wird. Dabei sind die Leitungen (Kapillaren) 30 der Heat Pipe, die miteinander verbunden und mit dem Arbeitsmedium befüllt sind, in die Wände des Kanals integriert. Aus Gründen der Übersichtlichkeit sind diese Leitungen in der Figur im Querschnitt dargestellt, sie können aber auch anders verlaufen und werden hinsichtlich der erzielten Kühlung optimiert. Die pulsierende Heat Pipe führt die Wärme vorzugsweise über Kühlrippen 31 ab, die in den Kanal hineinragen und beispielsweise mit Luft oder Wasser gekühlt werden.

Figur 6 stellt schematisch ein Beispiel für die Kühlung der pulsierenden Heat Pipe gemäß Figur 4 dar: es wird kalte Luft 32 durch den Kanal geleitet. An der entgegengesetzten Seite wird die durch die Kühlrippen im Innern des Kanals erwärmte Luft 33 herausgeführt.

Figur 7 zeigt eine Ausführungsform, bei der als zweiphasige Kühlung eine Loop Heat Pipe eingesetzt wird. Bei einer derartigen Heat Pipe zirkuliert das Arbeitsmedium aufgrund von Kapillarkräften durch die Leitung 40. Der mit den Chips bestückte Kanal dient als Verdampfer. Vorzugsweise wird das gesamte Innere des Kanals 1 als Verdampfer genutzt. Der Kanal besitzt daher Wände 2a an der Eintritts- und der Austrittsseite der Leitungen 40, in die die Leitungen 40 münden und die den Kanal abdichten. Wie bei der Ausführungsform gemäß Figur 2 kann der Kanal eine innere Struktur für die Führung des Arbeitsmediums aufweisen, um die Wärmeaufnahme und die Verdampfung zu optimieren.

## Patentansprüche

1. Verfahren zum Kühlen von Halbleiterchips bei dem die Chips (3) auf Wänden (2) eines Kanals (1) angeordnet sind, und
bei dem das Innere des Kanals mittels einer zweiphasigen Kühlung gekühlt wird.

2. Verfahren nach Anspruch 1,
**dadurch gekennzeichnet, dass** als zweiphasige Kühlung eine Sprühkühlung eingesetzt wird.

3. Verfahren nach einem der vorhergehenden Ansprüche,
**dadurch gekennzeichnet, dass** ein Arbeitsmedium mit einer steuerbaren Pumpe durch einen Kühlkreislauf gepumpt wird.

4. Verfahren nach Anspruch 1,
**dadurch gekennzeichnet, dass** für die zweiphasige Kühlung ein passives zweiphasiges Kühlverfahren verwendet wird.

5. Verfahren nach Anspruch 1 oder 4,
**dadurch gekennzeichnet, dass** als zweiphasige Kühlung ein Thermosiphon-Kühlkreislaufverfahren eingesetzt wird.

6. Verfahren nach Anspruch 1 oder 4,
**dadurch gekennzeichnet, dass** für die zweiphasige Kühlung eine Heat Pipe (Wärmerohr) eingesetzt wird.

7. Verfahren nach Anspruch 1 oder 4,
**dadurch gekennzeichnet, dass** für die zweiphasige Kühlung eine pulsierende Heat Pipe eingesetzt wird.

8. Verfahren nach Anspruch 7,
**dadurch gekennzeichnet, dass** eine Wand (2) des Kanals (1) als pulsierende Heatpipe ausgebildet ist und Kapillaren (30) der Heat Pipe in der Wand angeordnet sind.

9. Verfahren nach Anspruch 7 oder 8,
**dadurch gekennzeichnet, dass** die pulsierende Heat Pipe über Kühlrippen (31) im Inneren des Kanals (1) gekühlt wird.

10. Verfahren nach einem der vorhergehenden Ansprüche,
**dadurch gekennzeichnet, dass** ein Kanal (1) mit sechs Wänden (2) verwendet wird.

11. Verfahren nach einem der vorhergehenden Ansprüche,
**dadurch gekennzeichnet, dass** die Wände (2) des Kanals durch ein Substrat oder eine Leiterplatte gebildet werden, auf dem die Chips (3) montiert sind.

12. Verfahren nach einem der vorhergehenden Ansprüche,
**dadurch gekennzeichnet, dass** die Chips (3) außen und/oder innen auf den Wänden (2) des Kanals angeordnet sind.

13. Anordnung zum Kühlen von Halbleiter-Chips
▪ mit einem Kanal (1), auf dessen Wänden (2) die Chips (3) angeordnet sind.
▪ bei der im Kanal (1) oder in den Wänden des Kanals eine Komponente einer zweiphasigen Kühleinrichtung angeordnet ist.

14. Anordnung nach dem vorhergehenden Anspruch,
**dadurch gekennzeichnet, dass** die Komponente einen Verdampfer eines Thermosiphon-Kühlkreislaufs bildet.

15. Anordnung nach Anspruch 13,
**dadurch gekennzeichnet, dass** die Komponente einen Teil einer Heat Pipe (Wärmerohr) bildet.

16. Anordnung nach Anspruch 13 oder 15,
**dadurch gekennzeichnet, dass** mindestens eine Wand (2) des Kanals eine Leitung (30) aufweist, die eine Kapillare einer pulsierenden Heat Pipe bildet.

17. Anordnung nach Anspruch 13 oder 15,
**dadurch gekennzeichnet, dass** mindestens eine Wand des Kanals eine Kühlrippe (31) aufweist, die in den Kanal (1) hineinragt.

18. Anordnung nach Anspruch 13,
**dadurch gekennzeichnet, dass**
die Komponente eine Leitung (20) mit einer Düse (21) für ein Sprühkühlverfahren bildet.

19. Anordnung nach einem der vorhergehenden Ansprüche,
**dadurch gekennzeichnet, dass**
der Kanal (1) sechs Wände (2) aufweist.

20. Anordnung nach einem der vorhergehenden Ansprüche,
**dadurch gekennzeichnet, dass**
die Wände (2) des Kanals (1) durch ein Substrat oder eine Leiterplatte gebildet werden, auf dem die Chips (3) montiert sind.

21. Anordnung nach einem der vorhergehenden Ansprüche,
**dadurch gekennzeichnet, dass**
die Chips (3) außen und/oder innen auf den Wänden (2) des Kanals (1) angeordnet sind.
